# EUROPEAN PATENT APPLICATION

(11) **EP 2 239 797 A1**
(43) Date of publication of application: **13.10.2010**
(21) Application number: 08869845.1
(22) Date of filing: 25.12.2008
(51) Int. Cl.: H01L 51/42, C07C 69/618

(54) **COMPOSITION CONTAINING FULLERENE DERIVATIVE AND ORGANIC PHOTOELECTRIC CONVERTER USING THE SAME**

(30) Priority: 09.01.2008 JP 2008001932; 05.08.2008 JP 2008201646
(71) Applicant: Sumitomo Chemical Company, Limited, Tokyo 104-8260 (JP)
(72) Inventor: UETANI, Yasunori, Tsukuba-shi Ibaraki 305-0045 (JP); MORIWAKI, Shota, Tsukuba-shi Ibaraki 305-0821 (JP)
(74) Representative: Vossius & Partner
(86) International application number: PCT/JP2008/073945
(87) International publication number: WO 2009/087948

(57) **Abstract**

Disclosed is a composition which is **characterized by** obtained by bringing an adsorbent into contact with a composition containing a fullerene derivative and a solvent.

## Description

### Technical field

The present invention relates to a composition containing a fullerene derivative and an organic photoelectric converter using the same.

### Background art

Fullerene derivatives can be an organic semiconductor material having electric charge (electron, hole) transport properties, and it is expected that they will be applied, for example, to organic photoelectric converters (organic solar battery, optical sensor and the like). For example, it is known to use a composition including [6, 6]phenylbutyric acid methyl ester derivative of C₇₀ fullerene (hereinafter, also referred to as [70] PCBM) and chlorobenzene for an organic solar battery (Angew. Chem. Int. Ed. 2003, 42, pp.3371-3375).

### Disclosure of invention

However, when a composition containing a fullerene derivative and a solvent is used for an organic photoelectric converter of an organic solar battery or the like, efficiency of the photoelectric converter was not necessarily adequate.

It is an object of the present invention to provide a composition capable of imparting excellent photoelectric conversion efficiency when used for an organic photoelectric converter.

In a first aspect, the present invention provides a composition obtained by bringing a adsorbent into contact with a composition containing a fullerene derivative and a solvent.

In a second aspect, the present invention provides a composition obtained by adding an adsorbent to a composition containing a fullerene derivative and a solvent, and removing the adsorbent after purifying the composition.

In a third aspect, the present invention provides an organic photoelectric converter having a pair of electrodes at least one of which is transparent or translucent, and a layer formed between the electrodes by using the composition.

In a fourth aspect, the present invention provides a method of producing a composition comprising adding an adsorbent to a composition containing a fullerene derivative and a solvent, and removing the adsorbent after purifying the composition.

### Mode for carrying out the invention

The composition of the present invention is a composition obtained by bringing an adsorbent into contact with a composition containing a fullerene derivative and a solvent. Examples of the composition of the present invention include a composition obtained by adding an adsorbent to a composition containing a fullerene derivative and a solvent, and removing the adsorbent after purification of the composition, and a composition obtained by making a composition containing a fullerene derivative and a solvent pass through a column filled with an adsorbent.

Examples of the fullerene derivative include C₆₀, C₇₀, C₈₄, carbon nanotube, and derivatives thereof.

Examples of the derivative of C₆₀ include the following.

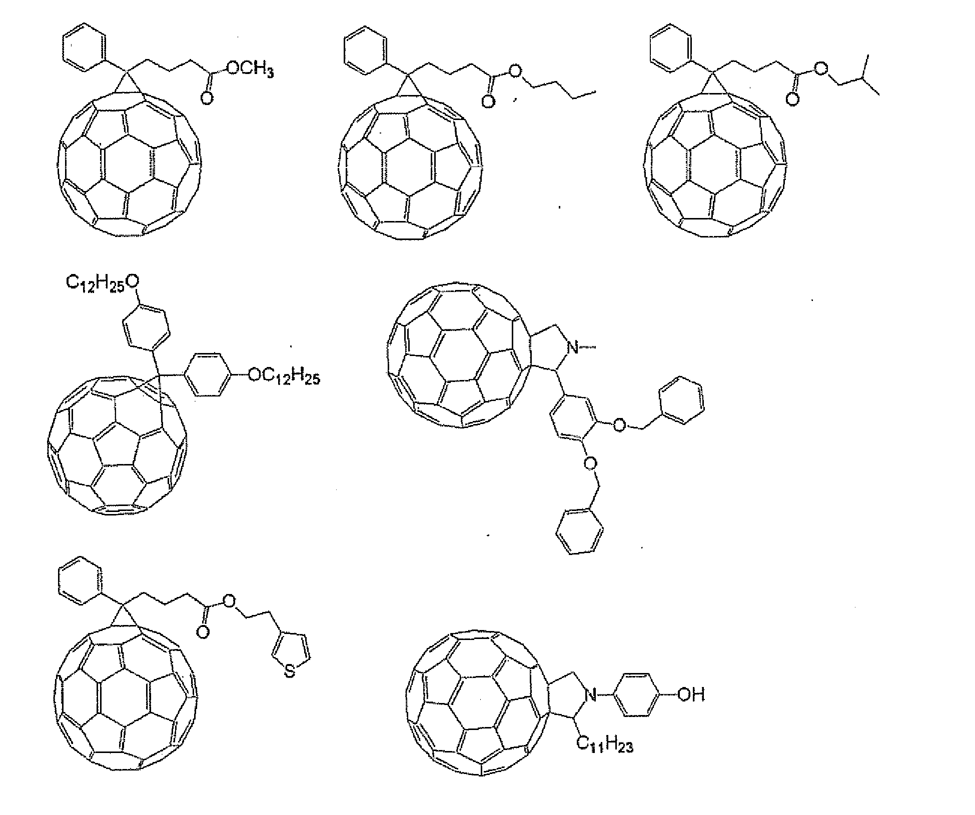

Examples of the derivative of C₇₀ include the following.

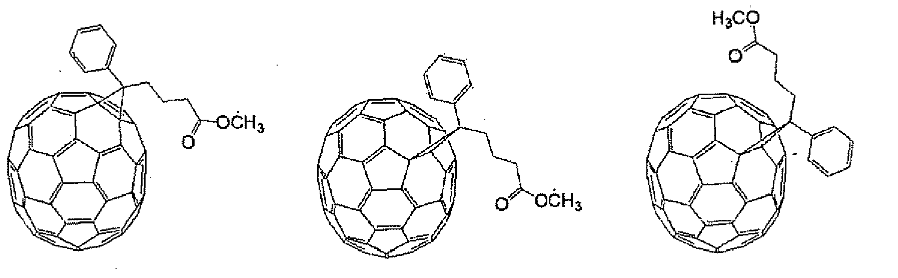

Examples of the solvent used in the present invention include hydrocarbon solvents such as toluene, xylene, mesitylene, tetralin, decalin, bicyclohexyl, n-butylbenzene, i-butylbenzene, sec-butylbenzene and t-butylbenzene, halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane, halogenated unsaturated hydrocarbon solvents such as chlorobenzene, dichlorobenzene and trichlorobenzene, and ether solvents such as tetrahydrofuran and tetrahydropyran.

In the composition used in the present invention, preferably, 1 part by weight to 100 parts by weight of the fullerene derivative is contained, relative to 1000 parts by weight of the solvent.

Examples of the adsorbent used in the present invention include those used as a filler of chromatography or as a filtration assistant. Examples of the filler of chromatography include silica gel, alumina, zeolite, activated carbon, a porous polymer, dextran gel (Sephadex), polyacrylamide gel (Biogel P), an ion exchange resin, a cellulose ion exchanger, a Sephadex ion exchanger, cellulose powder and Celite. Examples of the filtration assistant include diatomite, perlite, and a carbon-based filtration assistant. From the view point of selective adsorption of impurities, a metal oxide or an oxide of silicon is preferred, an oxide of typical metal or an oxide of silicon is more preferred, and silica gel, alumina and zeolite are further preferred. It is preferred that the surface of the adsorbent is hydrophilic from the view point of adsorption of impurities.

The amount of the adsorbent that is brought into contact with the composition used in the present invention is preferably 1 to 100000 parts by weight, more preferably 10 to 100000 parts by weight, and still preferably 100 to 100000 parts by weight, relative to 100000 parts by weight of the solvent contained in the composition.

For purification in the present invention, a method of leaving the composition as it is after addition of the adsorbent, a method of stirring the composition after addition of the adsorbent and so on are shown, and the method of stirring is preferred. The leaving time is preferably 1 hour to 100 hours, and the stirring time is preferably 1 minute to 100 hours.

Stirring may be conducted at room temperature, or conducted under heating, and the temperature is usually in the range from -20°C to 200°C.

Removal of the adsorbent in the present invention can be conducted, for example, by filtration using a filter.

By bringing the adsorbent into contact with the composition, impurities in the composition will be removed from the composition usually by being adsorbed by the adsorbent.

Examples of the impurities removed by the adsorbent include a compound generated by oxidization of a fullerene derivative, and a compound generated as a result of hydrolysis of an ester group when the fullerene derivative has such an ester group in its side chain.

In the present invention, the composition may further contain an electron donating compound. The electron-donating compound may be a low molecular compound or a high molecular compound. Examples of the low molecular compound include phthalocyanine, metallic phthalocyanine, porphyrin, metallic porphyrin, oligothiophene, tetracene, pentacene and rubrene. Examples of the high molecular compound include polyvinylcarbazole and its derivative, polysilane and its derivative, a polysiloxane derivative having aromatic amine in its side chain or main chain, polyaniline and its derivative, polythiophene and its derivative, polypyrrole and its derivative, polyphenylenevinylene and its derivative, polythienylenevinylene and its derivative, and polyfluorene and its derivative. From the view point of coating performance of the composition obtained by purification, a high molecular compound is preferred.

When the composition of the present invention contains an electron-donating compound, the amount of the fullerene derivative is preferably 10 to 1000 parts by weight, and more preferably 50 to 500 parts by weight, relative to 100 parts by weight of the electron-donating compound.

The composition of the present invention is a composition obtained by bringing an adsorbent into contact with a composition containing a fullerene derivative and a solvent, usually followed by removal of the adsorbent.

The composition of the present invention may be a fullerene derivative or a composition obtained by further removing the solvent after removal of the adsorbent.

### <Organic photoelectric converter>

The organic photoelectric converter of the present invention has a pair of electrodes at least one of which is transparent or translucent, and a layer formed between the electrodes by using the composition of the present invention.

Next, an operation mechanism of the organic photoelectric converter will be described. Optical energy incident from the transparent or translucent electrode is absorbed in an electron-accepting compound and/or an electron-donating compound, to generate an excitor in which an electron and a hole are bonded to each other. As the generated excitor moves to reach a heterojunction interface where the electron-accepting compound and the electron-donating compound are adjacent to each other, the electron and the hole disassociate due to difference in respective HOMO energy and LUMO energy at the interface, and electric charges (electron and hole) capable of independently moving are generated. The generated electric charges move to respective electrodes, and thus they can be taken out externally as electric energy (electric current).

Examples of the organic photoelectric converter of the present invention include an organic photoelectric converter having a pair of electrodes at least one of which is transparent or translucent, and at least one layer as an organic layer formed between the electrodes made of the composition of the present invention.

The organic photoelectric converter of the present invention may be provided with an additional layer between at least one of the electrodes and the organic layer in the converter. The additional layer may be, for example, a charge transport layer for transporting a hole or an electron.

The organic photoelectric converter of the present invention may have a layer containing an electron-donating compound, in addition to the layer formed by using the composition of the present invention, in particular, when the composition of the present invention does not contain an electron-donating compound. After adding an electron-donating compound to the composition of the present invention, a layer contained in the organic photoelectric converter may be formed. The electron-donating compound can be the compounds as described above.

When an electron-donating compound is added to the composition, an amount of the fullerene derivative is preferably 10 to 1000 parts by weight, and more preferably 50 to 500 parts by weight, relative to 100 parts by weight of the electron-donating compound.

The thickness of the layer formed of the composition of the present invention is usually 1 nm to 100 µm, preferably 2 nm to 1000 nm, more preferably 5 nm to 500 nm, and still preferably 20 nm to 200 nm.

The organic photoelectric converter of the present invention is usually formed on a substrate. The substrate forms electrodes, and any substrate can be used unless it does not change during formation of layers of organic substances. Examples of the material of the substrate include glass, plastic, polymer film and silicon. In the case of using an opaque substrate, the electrode farther from the substrate (opposite electrode) is preferably transparent or translucent.

For the aforementioned transparent or translucent electrode material, a conductive metal oxide film, a translucent metal thin film and so on are used. Concretely, films (MESA etc.) produced by using conductive materials including indium oxide, zinc oxide, tin oxide, and complexes thereof, such as indium tin oxide (ITO) and indium zinc oxide, and gold, platinum, silver, copper and the like are used. ITO, indium zinc oxide, and tin oxide are preferred. Examples of the method of producing an electrode include a vacuum vapor deposition method, a sputtering method, an ion plating method, and a plating method. For an electrode material, an organic transparent conductive film of polyaniline and its derivative, polythiophene and its derivative and so on may be used. Further, metal, a conductive polymer and so on may be used for an electrode material. Preferably, one electrode of the pair of electrodes is made of a material having small work function. For example, metal such as lithium, sodium, potassium, rubidium, cesium, magnesium, calcium, strontium, barium, aluminum, scandium, vanadium, zinc, yttrium, indium, cerium, samarium, europium, terbium and ytterbium, and alloys of two or more of them, or alloys of one or more of them and at least one selected from gold, silver, platinum, copper, manganese, titanium, cobalt, nickel, tungsten and tin, graphite or a graphite intercalation compound and the like are used.

Examples of the alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

A material that is used for a buffer layer which is an additive layer can be halides, oxides or the like of alkaline metal or alkaline earth metal such as lithium fluoride. Microparticles of inorganic semiconductor such as titanium oxide also can be used.

### <Production method of organic layer>

A method of producing the organic layer, for example, can be a method of film formation of the composition of the present invention.

For the film formation, application methods such as a spin coating method, a casting method, a microgravure coating method, a gravure coating method, a bar coating method, a roll coating method, a wire bar coating method, a dip coating method, a spray coating method, a screen printing method, a flexo printing method, an offset printing method, an inkjet printing method, a dispenser printing method, a nozzle coating method and a capillary coating method can be used, and the spin coating method, the flexo printing method, the inkjet printing method, and the dispenser printing method are preferred.

The organic photoelectric converter of the present invention enables an operation as an organic thin film solar battery, as photovoltaic power arises between the electrodes by emitting light such as sunlight from the transparent or translucent electrode.

The organic photoelectric converter can be used for an organic thin film solar battery module by integrating a plurality of organic thin film solar batteries.

By emitting light from the transparent or translucent electrode while voltage is applied between the electrodes, photocurrent flows, which enables operation as an organic light sensor. Further, integrating a plurality of organic light sensors enables use as an organic image sensor.

### Examples

In the following, examples will be given for describing the present invention in more details. However, the present invention will not be limited to the examples.

In the following examples, number average molecular weight and weight average molecular weight in terms of polystyrene were determined by GPC (PL-GPC2000) manufactured by GPC Laboratory. As a sample for measurement, a solution dissolving a polymer in o-dichlorobenzene at about 1% by weight was used. A moving phase of GPC is o-dichlorobenzene, which was allowed to flow at a flow rate of 1 mL/min. at a measurement temperature of 140°C. For a column, the one made up of three PLGEL 10 µL MIXEd-B (manufactured by Polymer Laboratories, Ltd.) connected in series was used.

### Synthesis Example 1

### (Synthesis of Polymer 1)

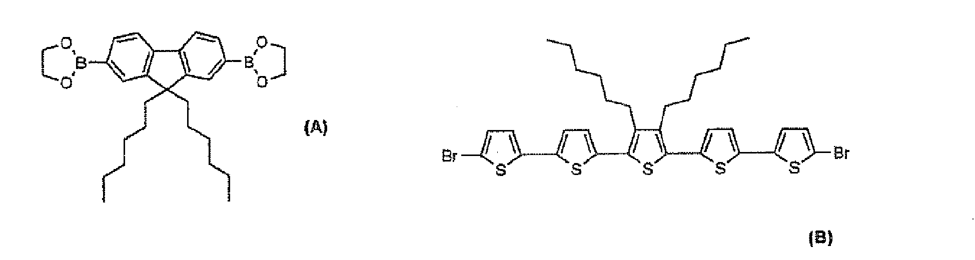

A 2L four-neck flask, an atmosphere in which was replaced by argon, was charged with Compound A (7.928 g, 16.72 mmol), Compound B (13.00 g, 17.60 mmol), methyltrioctylammonium chloride (trade name: aliquat 336, manufactured by Aldrich, Inc., CH₃N[(CH₂)₇CH₃]₃Cl, density 0.884 g/mL, 25°C, trademark of Henkel Corporation) (4.979 g), and 405 mL of toluene, and the interior of the system was argon-bubbled for 30 minutes under stirring. Dichlorobis(triphenylphosphine)palladium (II) (0.02 g) was added thereto, and 42.2 mL of 2 mol/L sodium carbonate aqueous solution was added dropwise while the temperature was elevated to 105 °C under stirring. After termination of the dropwise addition, the reaction was conducted for 5 hours. Phenylboronic acid (2.6 g) and 1.8 mL of toluene were added to the reactant, and stirred for 16 hours at 105°C. Toluene (700 mL) and 7.5% sodium diethyldithiocarbamate trihydrate aqueous solution (200 mL) were added thereto, and the mixture was stirred at 85°C for 3 hours. Following removal of the aqueous phase, washing with 300 mL of ion exchange water at 60°C was conducted twice, washing with 300 mL of 3% acetic acid at 60°C was conducted once, and washing with 300 mL ion exchange water at 60°C was conducted three times. The organic phase was made to flow through a column charged with Celite, alumina and silica, and the column was washed with 800 mL of hot toluene. After being concentrated to 700 mL, the solution was poured into 2L of methanol to cause reprecipitation. Polymers were collected by filtration, and washed with 500 mL of methanol, acetone and methanol. Through vacuum drying at 50°C overnight, 12.21 g of a pentathienyl-fluorene copolymer (hereinafter, referred to as "Polymer 1") represented by the following formula was obtained.

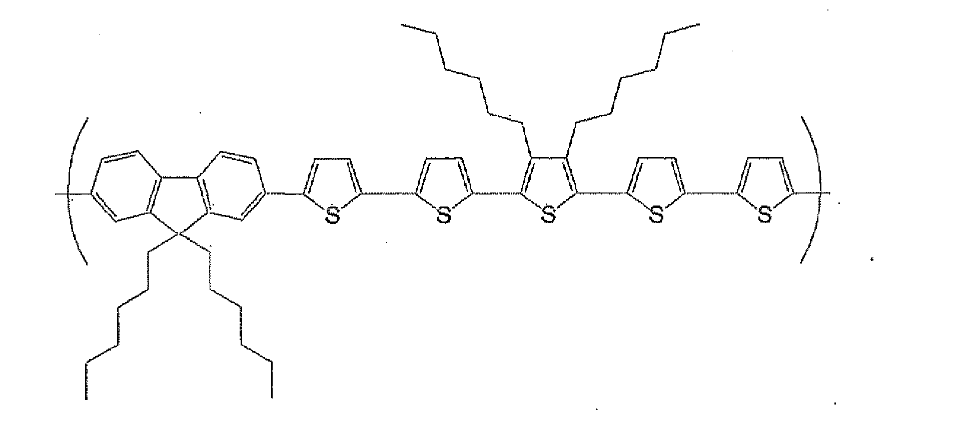

The number average molecular weight was 5.4×10⁴, and the weight average molecular weight was 1.1×10⁵ in terms of polystyrene of Polymer 1.

### Synthesis Example 2

### (Synthesis of mixture of a hydrolytic product of a fullerene derivative and a fullerene derivative (Compound C))

To 50 mg (0.05 mmol) of [70]PCBM (ADS71BFA LOT number: 07G058E, manufactured by American Dye Source, Inc.), 5 mL of toluene and 5 mL of tetrahydrofuran were added, and the mixture was stirred for 3 hours at room temperature to dissolve the same. Then the system was added with 5 mL of 2M sodium hydroxide aqueous solution, and stirred for 10 hours at room temperature.

After termination of the stirring, the sodium hydroxide aqueous solution was removed, and 5 mL of 1. 7M hydrochloric acid aqueous solution was added thereto, and the mixture was stirred for 12 hours. Then after removal of the hydrochloric acid aqueous solution, the same operation was repeated and then 5 mL of ion exchange water was added for washing, and was removed, and then the obtained organic phase was dried over magnesium sulfate, filtered off, and concentrated, to obtain 50 mg of a mixture of a hydrolytic product of a fullerene derivative and a fullerene derivative. This is called Compound C.

### Example 1

### (Production of Composition 1)

Twenty-five (25) parts by weight of [70]PCBM (ADS71BFA LOT number: 07G058E, manufactured by American Dye Source, Inc.) as a fullerene derivative, 5 parts by weight of Polymer 1 as an electron-donating compound, and 1000 parts by weight of o-dichlorobenzene as a solvent were mixed. Then as an adsorbent, 10 parts by weight of silica gel (Wakogel C-300 manufactured by Wako Pure Chemical Industries, Ltd. , particle size 45-75 µm) was added thereto, and the mixture was stirred at 23°C for 12 hours. Then the adsorbent was filtered off by Teflon (registered name) filter having a pore diameter of 1.0 µm, to produce Composition 1.

### Example 2

### (Production of Composition 2)

Twenty-two and a half (22.5) parts by weight of [70]PCBM (ADS71BFA LOT number:07G058E, manufactured by American Dye Source, Inc.) as a fullerene derivative, 5 parts by weight of Polymer 1 as an electron-donating compound, 1000 parts by weight of o-dichlorobenzene as a solvent, and 2.5 parts by weight of Compound C were mixed. Then as an adsorbent, 10 parts by weight of silica gel (Wakogel C-300 manufactured by Wako Pure Chemical Industries, Ltd., particle size 45-75 µm) was added thereto, and the mixture was stirred at 23°C for 12 hours. Then the adsorbent was filtered off by Teflon (registered name) filter having a pore diameter of 1.0 µm, to produce Composition 2.

### Example 3

### (Production of Composition 3)

Fifteen (15) parts by weight of [70] PCBM (E110 LOT number: 7A0170-D, manufactured by Frontier Carbon Corporation) as a fullerene derivative, 5 parts by weight of Polymer 1 as an electron-donating compound, and 1000 parts by weight of o-dichlorobenzene as a solvent were mixed. Then as an adsorbent, 10 parts by weight of silica gel (Wakogel C-300 manufactured by Wako Pure Chemical Industries, Ltd., particle size 45-75 µm) was added thereto, and the mixture was stirred at 23°C for 12 hours. Then the adsorbent was filtered off by Teflon (registered name) filter having a pore diameter of 1.0 µm, to produce Composition 3.

### Example 4

### (Production of Composition 4)

Fifteen (15) parts by weight of [70]PCBM (E110 LOT number: 7A0170-D, manufactured by Frontier Carbon Corporation) as a fullerene derivative, 5 parts by weight of Polymer 1 as an electron-donating compound, and 1000 parts by weight of o-dichlorobenzene as a solvent were mixed. Then as an adsorbent, 10 parts by weight of alumina (active alumina manufactured by Wako Pure Chemical Industries, Ltd., particle size ≤75 µm pH=9-11) was added thereto, and the mixture was stirred at 23°C for 12 hours. Then the adsorbent was filtered off by Teflon (registered name) filter having a pore diameter of 1.0 µm, to produce Composition 4.

### Example 5

### (Production of Composition 5)

Fifteen (15) parts by weight of [60]PCBM (E100 LOT number: 7B084-A, manufactured by Frontier Carbon Corporation) as a fullerene derivative, 5 parts by weight of Polymer 1 as an electron-donating compound, and 1000 parts by weight of o-dichlorobenzene as a solvent were mixed. Then as an adsorbent, 10 parts by weight of silica gel (Wakogel C-300 manufactured by Mako Pure Chemical Industries, Ltd., particle size 45-75 µm) was added thereto, and the mixture was stirred at 23°C for 12 hours. Then the adsorbent was filtered off by Teflon (registered name) filter having a pore diameter of 1.0 µm, to produce Composition 5.

### Comparative Example 1

### (Production of Composition 6)

Twenty-five (25) parts by weight of [70]PCBM (ADS71BFA LOT number: 07G058E, manufactured by American Dye Source, Inc.) as a fullerene derivative, 5 parts by weight of Polymer 1 as an electron-donating compound, and 1000 parts by weight of o-dichlorobenzene as a solvent were mixed, to produce Composition 6.

### Comparative Example 2

### (Production of Composition 7)

Twenty-two and a half (22.5) parts by weight of [70] PCBM (ADS71BFA LOT number: 07G058E, manufactured by American Dye Source, Inc.) as a fullerene derivative, 5 parts by weight of Polymer 1 as an electron-donating compound, 1000 parts by weight of o-dichlorobenzene as a solvent, and 2.5 parts by weight of Compound C were mixed, to produce Composition 7.

### Comparative Example 3

### (Production of Composition 8)

Fifteen (15) parts by weight of [70] PCBM (E110 LOT number: 7A0170-D, manufactured by Frontier Carbon Corporation) as a fullerene derivative, 5 parts by weight of Polymer 1 as an electron-donating compound, and 1000 parts by weight of o-dichlorobenzene as a solvent were mixed, to produce Composition 8.

### Comparative Example 4

### (Production of Composition 9)

Fifteen (15) parts by weight of [60] PCBM (E100 LOT number: 7B084-A, manufactured by Frontier Carbon Corporation) as a fullerene derivative, 5 parts by weight of Polymer 1 as an electron-donating compound, and 1000 parts by weight of o-dichlorobenzene as a solvent were mixed, to produce Composition 9.

### Example 6

### (Production and evaluation of organic thin film solar battery)

A glass substrate attached with an ITO film of 150 nm thick by sputtering was subjected to a surface treatment by ozone UV treatment. Then Composition 1 was applied by spin coating, to obtain an active layer of an organic thin film solar battery (having a film thickness of about 180 nm (thickness of active layer is shown in Table 1)). Thereafter, drying was effected at room temperature in vacuum for 60 minutes. Then lithium fluoride was vapor-deposited at a film thickness of 4 nm by a vacuum deposition machine, and then Al was vapor-deposited at a film thickness of 100 nm. The degree of vacuum at the time of deposition was 1 to 9×10⁻³ Pa in any cases. The shape of the obtained organic thin film solar battery was a square of 2 mm x 2mm. The obtained organic thin film solar battery was irradiated with constant light using a solar simulator (trade name OTENTO-SUNII: AM1.5G filter, radiation illuminance 100 mW/cm², manufactured by BUNKOUKEIKI Co., Ltd.), and generating current and voltage were measured to determine photoelectric conversion efficiency. The measurement results are shown in Table 1.

### Example 7

### (Production and evaluation of organic thin film solar battery)

An organic thin film solar battery was produced in the same manner as in Example 6 except that Composition 2 was used in place of Composition 1, and photoelectric conversion efficiency was measured. The measurement results are shown in Table 1.

### Example 8

### (Production and evaluation of organic thin film solar battery)

A glass substrate attached with an ITO film of 150 nm thick by sputtering was subjected to a surface treatment by ozone UV treatment. Then Composition 3 was applied by spin coating, to obtain an active layer of an organic thin film solar battery (having a film thickness of about 100 nm (thickness of active layer is shown in Table 1)). Thereafter, drying was effected at room temperature in vacuum for 60 minutes. Then lithium fluoride was vapor-deposited at a film thickness of 4 nm by a vacuum deposition machine, and then Al was vapor-deposited at a film thickness of 100 nm. The degree of vacuum at the time of deposition was 1 to 9×10⁻³ Pa in any cases. The shape of the obtained organic thin film solar battery was a square of 2 mm x 2mm. The obtained organic thin film solar battery was irradiated with constant light using a solar simulator (trade name OTENTO-SUNII: AM1.5G filter, radiation illuminance 100 mW/cm², manufactured by BUNKOUKEIKI Co., Ltd.), and generating current and voltage were measured to determine photoelectric conversion efficiency. The measurement results are shown in Table 1.

### Example 9

### (Production and evaluation of organic thin film solar battery)

An organic thin film solar battery was produced in the same manner as in Example 8 except that Composition 4 was used in place of Composition 3, and photoelectric conversion efficiency was measured. The measurement results are shown in Table 1.

### Example 10

### (Production and evaluation of organic thin film solar battery)

An organic thin film solar battery was produced in the same manner as in Example 8 except that Composition 5 was used in place of Composition 3, and photoelectric conversion efficiency was measured. The measurement results are shown in Table 1.

### Comparative Example 5

### (Production and evaluation of organic thin film solar battery)

An organic thin film solar battery was produced in the same manner as in Example 6 except that Composition 6 was used in place of Composition 1, and photoelectric conversion efficiency was measured. The measurement results are shown in Table 1.

### Comparative Example 6

### (Production and evaluation of organic thin film solar battery)

An organic thin film solar battery was produced in the same manner as in Example 6 except that Composition 7 was used in place of Composition 1, and photoelectric conversion efficiency was measured. The measurement results are shown in Table 1.

### Comparative Example 7

### (Production and evaluation of organic thin film solar battery)

An organic thin film solar battery was produced in the same manner as in Example 8 except that Composition 8 was used in place of Composition 3, and photoelectric conversion efficiency was measured. The measurement results are shown in Table 1.

### Comparative Example 8

### (Production and evaluation of organic thin film solar battery)

An organic thin film solar battery was produced in the same manner as in Example 8 except that Composition 9 was used in place of Composition 3, and photoelectric conversion efficiency was measured. The measurement results are shown in Table 1.

### Example 11

### (Production of Composition 10)

Fifteen (15) parts by weight of [70]PCBM (ADS7IBFA LOT number: 8C059E, manufactured by American Dye Source, Inc.) as a fullerene derivative, 5 parts by weight of Polymer 1 as an electron-donating compound, and 1000 parts by weight of o-dichlorobenzene as a solvent were mixed. Then as a metal ion adsorbent, 100 parts by weight of ion exchange resin (Amberlyst 15JS-HG·DRY, manufactured by ORGANO CORPORATION) was added thereto, and the mixture was stirred for 12 hours. Then the adsorbent was filtered off by Teflon (registered name) filter having a pore diameter of 1.0 µm, to produce Composition 10.

### Example 12

### (Production and evaluation of organic thin film solar battery)

An organic thin film solar battery was produced in the same manner as in Example 8 except that Composition 10 was used in place of Composition 3, and photoelectric conversion efficiency was measured. The measurement results are shown in Table 1.

### Comparative Example 9

### (Production of Composition 11)

Fifteen (15) parts by weight of 70] PCBM (ADS71BFA LOT number: 8C059E, manufactured by American Dye Source, Inc.) as a fullerene derivative, 5 parts by weight of Polymer 1 as an electron-donating compound, and 1000 parts by weight of o-dichlorobenzene as a solvent were mixed, to produce Composition 11.

### Comparative Example 10

### (Production and evaluation of organic thin film solar battery)

An organic thin film solar battery was produced in the same manner as in Example 8 except that Composition 11 was used in place of Composition 3, and photoelectric conversion efficiency was measured. The measurement results are shown in Table 1.

**Table 1**

| | Fullerene derivative (weight ratio relative to electron donor) | Adsorbent (% by weight relative to solution) | Film thickness (nm) | Photoelectric conversion efficiency (%) |
|---|---|---|---|---|
| Example 6 | ADS71BFA | Silica gel | 180 | 4.9 |
| | (5.0) | (1.0) | | |
| Example 7 | ADS71BFA/Compound C | Silica gel | 180 | 4.4 |
| | (4.5/0.5) | (1.0) | | |
| Example 8 | E110 | Silica gel | 100 | 2.6 |
| | (3.0) | (1.0) | | |
| Example 9 | E110 | Alumina | 100 | 2.2 |
| | (3.0) | (1.0) | | |
| Example 10 | E110 | Silica gel | 100 | 3.3 |
| | (3.0) | (1.0) | | |
| Example 12 | ADS71BFA | Ion exchange | 100 | 4.5 |
| | | resin | | |
| | (3.0) | (10.0) | | |
| Comparative Example 5 | ADS71BFA | None | 180 | 4.3 |
| | (5.0) | | | |
| Comparative Example 6 | ADS71BFA/Compound C | None | 180 | 3.8 |
| | (4.5/0.5) | | | |
| Comparative Example 7 | E110 | None | 100 | 1.8 |
| | (3.0) | | | |
| Comparative Example 8 | E110 | None | 100 | 3.0 |
| | (3.0) | | | |
| Comparative Example 10 | ADS71BFA | None | 100 | 3.8 |
| | (3.0) | | | |

### -Evaluation-

As is apparent from Table 1, organic photoelectric converters produced by using a composition subjected to an adsorption treatment with silica gel, alumina or ion exchange resin exhibited higher photoelectric conversion efficiency than organic photoelectric converters produced by using a composition not subjected to such an adsorption treatment.

### Industrial applicability

The present invention is industrially very useful because an organic photoelectric converter showing excellent photoelectric conversion efficiency can be produced by using the composition of the present invention.

## Claims

1. A composition obtained by bringing a composition containing a fullerene derivative and a solvent into contact with an adsorbent.

2. The composition according to claim 1, obtained by adding an adsorbent to a composition containing a fullerene derivative and a solvent, and removing the adsorbent after purifying the composition.

3. The composition according to claim 1 or 2, wherein the composition further contains an electron-donating compound.

4. The composition according to any one of claim 1 to 3, wherein the adsorbent is a metal oxide or an oxide of silicon.

5. The composition according to claim 4, wherein the adsorbent is an oxide of typical metal.

6. The composition according to claim 4, wherein the adsorbent is silica gel.

7. The composition according to claim 4, wherein the adsorbent is alumina.

8. The composition according to claim 4, wherein the adsorbent is an ion exchange resin.

9. An organic photoelectric converter comprising a layer formed by using the composition according to any one of claims 1 to 8.

10. A method of producing a composition comprising: adding an adsorbent to a composition containing a fullerene derivative and a solvent, purifying the composition, and removing the adsorbent.
